(19) **Europäisches Patentamt / European Patent Office / Office européen des brevets**

(11) **EP 2 073 391 B1**

(12) # EUROPEAN PATENT SPECIFICATION

(45) Date of publication and mention
of the grant of the patent:
**08.06.2011 Bulletin 2011/23**

(51) Int Cl.:
*H04B 1/10* (2006.01)   *H03J 1/00* (2006.01)
*H04H 20/22* (2008.01)

(21) Application number: **07150398.1**

(22) Date of filing: **21.12.2007**

(54) **Method of operating a radio tuner, for detecting and responding to effects of tunnel situations on radio reception by an in-vehicle radio receiver**

Verfahren zum Betreiben eines Funkabstimmers zur Erkennung und Reaktion auf Auswirkungen der Tunnelsituationen beim Funkempfang durch einen Funkempfänger im Fahrzeug

Procédé de fonctionnement syntoniseur pour détecter et répondre aux effets des situations de tunnel sur la réception radio par un récepteur radio embarqué

(84) Designated Contracting States:
**DE FR GB**

(43) Date of publication of application:
**24.06.2009 Bulletin 2009/26**

(73) Proprietor: **FUJITSU TEN LIMITED**
**Hyogo-ku, Kobe-shi**
**Hyogo 652-8510 (JP)**

(72) Inventors:
• **Görtler, Michael**
**c/o Fujitsu Ten (Europe) GmbH**
**90449 Nürnberg (DE)**

• **Klinger, Thomas**
**c/o Fujitsu Ten (Europe) GmbH**
**90449 Nürnberg (DE)**

(74) Representative: **Ward, James Norman**
**Haseltine Lake LLP**
**Lincoln House, 5th Floor**
**300 High Holborn**
**London WC1V 7JH (GB)**

(56) References cited:
**EP-A- 0 503 202      EP-A- 1 195 897**
**DE-A1- 4 318 867**

**Description**

The invention relates to a method of operating a radio tuner for detecting and responding to a tunnel situation, i.e. the effect on radio reception such as arises when an in-vehicle radio receiver enters a tunnel.

In-vehicle reception of broadcast programmes using a radio receiving apparatus is well-known. Such reception suffers from difficulties which do not tend to occur for a stationary receiver because of the movement of the vehicle.

In particular, for receiving a radio signal at a stationary site a directional antenna such as a Yagi or dipole antenna may be used. This antenna is aimed in the direction of the transmitter site in such a fashion that the received signal originates mainly along a direct path with delayed and reflected signals arriving from lateral paths largely excluded.

In a vehicle, however, an omni-directional antenna needs to be used because the reception angle of the radio waves can adopt any value within 360 degrees. As a result of this, the vehicle receiver must be able to cope with all of the signals arriving at the receiving antenna, independent of the driving direction and the speed of the vehicle.

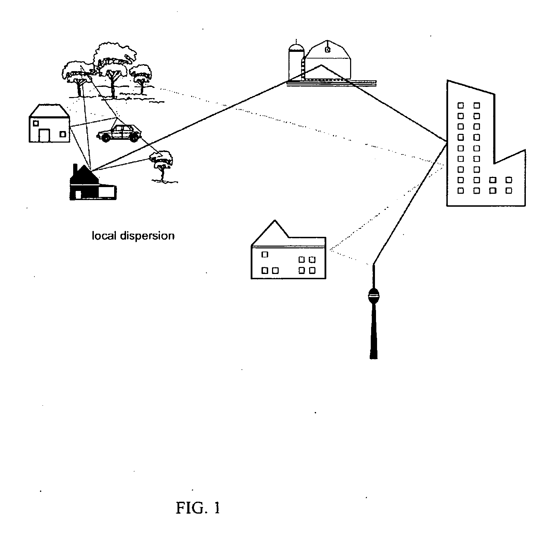

The signal received at the vehicle receiver suffers from multipath propagation and from Doppler shift, which is caused by the movement of the receiver itself or by moving reflecting obstacles. This is shown in Figure 1.

Here, two main propagation paths where the waves are reflected on discrete obstacles such as tall buildings, hills or mountain ridges can be seen. As the average length of the two paths is different, the signals will arrive at different time instants in the vicinity of the car. Additionally the signals are exposed to local dispersion due to further reflections in the immediate surrounding of the receiving antenna.

These influences lead to a sum signal at the antenna which is continuously varying in amplitude, phase and frequency. In consequence, this fading signal has a strong impact on the quality of the audio signal after demodulation in the receiver. In particular, for an FM signal the following may occur:

a) Heavy distortion due to missing parts of the FM signal spectrum;

b) Fluctuating noise occurring each time the signal level falls below the limiting threshold of the receiver;

c) Periodical noise bursts (paling fence effect) in case the fading signal is dominated by two main paths with Doppler shift.

One way of mitigating the above problems is to employ at least two independent antennae. Switching can then be performed such that the antenna which delivers the better signal is connected to the receiver input, thus providing more stable reception conditions. Another way of mitigating the problem is to use antenna phase diversity. Here, the signals of two independent antennae are fed to two tuners. The IF signals of both tuners are then processed so that they can be added and thus simultaneously contribute to a better reception signal.

These two methods are unable to help significantly in cases where the signal level becomes too low.

Therefore in Europe the Radio Data System (RDS) has been developed. This system provides a means for performing 'network following'. In the RDS system, detailed information about other frequencies of the same programme or transmitter chain are included in an RDS data channel of the received programme signal. This information enables a receiver to check for alternative frequencies on which the same programme (radio station broadcast) is transmitted, and to change the frequency to which it is tuned if its received signal level becomes too low. In other words, the receiver is able to use the RDS system to 'follow' a particular network (radio programme/channel broadcast) across different frequencies.

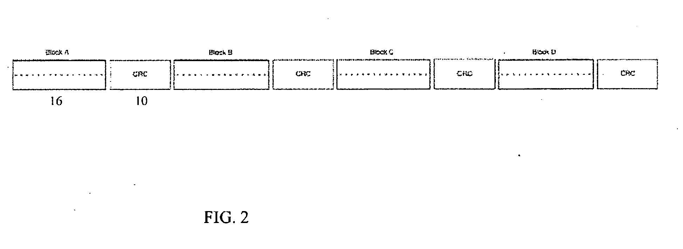

In the RDS system, a data link layer consists of blocks of data. Each block typically has 26 bits, consisting of 16 bits of data and 10 check bits. An RDS Group consists of 4 blocks, as shown in Figure 2. In the Group, block A includes a program identification (PI) code, which is the unique identifier of a radio station. The PI code is repeated 11.4 times per second and uniquely identifies a programme (radio station channel) and the country in which the programme is broadcast. In addition, use of the code enables selection of a programme independently of frequency, and further enables a receiver to perform automatic changes (i.e. without user input) of the received frequency so as to change to an alternative frequency on which the same or related programmes are broadcast. Also transmitted in the RDS data is alternative frequency information. The alternative frequency information includes the other frequencies on which the programme currently tuned to is also being broadcast. The PI code and the alternative frequency information enable the radio receiver to perform the above-described network following.

In a conventional in-vehicle radio receiver, a field-strength or level detector is provided. This detector detects the signal (field) strength of the channel tuned to. The field strength is directly related to signal quality because the signal-to-noise ratio mainly depends on it. The detector needs to be calibrated to compensate for the tolerances of the analogue components in the receiver hardware, so as to ensure that its output is an accurate reflection of the signal strength.

In the conventional receiver, when a particular frequency is tuned to and the detected field-strength of the received signal on that frequency falls below a pre-set threshold, stored alternative frequency information is searched and the alternative frequency having the best field-strength is tuned to. In other words, switching is performed between a first frequency on which a particular programme is broadcast to a second frequency on which the same programme is broadcast.

The stored alternative frequency information is maintained in the background by periodically tuning the tuner for a very brief time period to an alternative frequency. The time period for which the tuner is tuned to an alternative frequency is kept short enough so as not to noticeably disturb the sound heard by a listener. Each occasion on which the tuner is diverted from the tuned (listened to) frequency it is tuned to a different alternative frequency in a cyclic fashion, so that data (field strength) for all of the alternative frequencies is obtained.

It is also known to measure the multipath and noise of the frequency tuned to, i.e. of the frequency being listened to. The multipath can be measured using a multipath detector which evaluates amplitude fluctuations of the received signal. An FM signal is broadcast with a constant amplitude level, and hence fluctuations indicate a deterioration of signal quality. At multipath conditions large level fluctuations can be measured. The noise (ultra sonic noise) can be measured by considering the amplitude of the high frequency content of the multiplex signal.

Thus, by measuring the multipath and the noise of the received frequency, in addition to its field strength, a change of frequency tuned-to can be initiated if the detected multipath value or the detected noise value of the received frequency signal reaches a threshold. The alternative frequency selected to be switched to is the alternative frequency having the best field strength.

This method of network following suffers from substandard performance in certain situations. In particular, it can occur that the selected alternative frequency (i.e. the new frequency) has a large value of multipath and/or noise, despite having a high field strength. In this situation, the sound output by the receiver actually deteriorates after the change.

In addition, the switch may be performed to an alternative frequency but not to exactly the right frequency. For example, the frequency switched to could be 100 kHz beside the 'correct' alternative frequency. In this case the sound quality is also significantly deteriorated.

Further, a problem can occur in weak signal areas. Namely, due to the low signal strength a search is performed every few seconds to find a better alternative frequency. This leads to a large amount of mutes, and the resulting alternating change between a noisy sound and mute is very irritating to the listener.

EP 1195897 discloses a system wherein received signal qualities at the current reception frequency, and at one or more alternative frequencies, are determined. They are compared and the reception frequency is switched to an alternative frequency, if reception will be improved.

DE 43188667 discloses a radio apparatus wherein a controller switches on an audio attenuator in the receiver and suppresses noise during temporary loss of RF signal at the antenna. When reception conditions are not good enough for all alternative frequencies, the audio output is switched to another music source.

EP 0503202 discloses a method of controlling an RDS receiver which can switch between alternative frequencies when a vehicle is driving in a tunnel or mountainous area, by detecting a lock detection signal at unit time intervals.

Moreover, the inventors have realised that a particularly acute problem can arise when the vehicle, and its in-vehicle radio receiver, enters a tunnel. The change in signal reception conditions upon entering a tunnel (which can be referred to as the "tunnel situation") can defeat the network following method otherwise used such that the result is scarcely acceptable for the listener.

It is therefore desirable to provide a method by which the occurrence of a tunnel situation can be rapidly recognised, and also to provide a more satisfactory response to the tunnel situation, and a corresponding radio receiver apparatus, that can mitigate the above problems.

According to a first aspect of the invention, there is provided a method of operating a radio tuner, comprising:-

monitoring a quality indicator of a first frequency signal, to which the radio tuner is tuned, and
when the value of the quality indicator falls below a predetermined first quality indicator threshold value,
and the magnitude and the speed of the fall are greater than predetermined magnitude and speed threshold values,
searching for an alternative frequency signal carrying the same radio programme as the first frequency signal.

Thus, when the magnitude and speed of the fall in value of the quality indicator are greater than their predetermined threshold values it can be recognised that a tunnel situation is present, and an appropriate response effected.

Whether the magnitude and the speed of the fall in value of the quality indicator are greater than the predetermined magnitude and speed threshold values, may be determined by detecting a fall in the value of the quality parameter from a second predetermined quality indicator threshold value, greater than the first quality indicator threshold value by said predetermined magnitude threshold value, to the first quality indicator threshold value, and determining the time period over which the fall from second to first quality indicator threshold value occurred.

Alternatively, whether the magnitude and the speed of the fall in value of the quality indicator are greater than the predetermined magnitude and speed threshold values can be determined by detecting rates of change of the value of the quality indicator, and evaluating the rates of change detected during a predetermined period up to the value of the quality indicator falling below the first quality indicator threshold value.

Further alternatively, whether the magnitude and the speed of the fall in value of the quality indicator are greater than the predetermined magnitude and speed threshold values can be determined by detecting the values of the quality indicator at predetermined intervals and evaluating those values detected at intervals during a predetermined period up to the value of the quality indicator falling below the first quality indicator threshold value

As a response to the tunnel situation, it can be provided that upon the searching for an alternative frequency signal carrying the same radio programme as the first frequency signal, if no such alternative frequency signal is found, the radio remains tuned to the first frequency signal and the radio programme is played at reduced volume.

In an embodiment of the invention the quality indicator is a field strength quality value Q(FS) determined by:

detecting the field strength of the received, first frequency signal; and
performing a non-linear conversion on the detected field strength to convert it into the field strength quality value Q(FS).

The non-linear conversion may be performed based on a non-linear relationship between the field strength of the received signal and the signal-to-noise ratio of the audio output signal resulting from the received signal.

The non-linear conversion may be performed using a segmented interpolation, said segmented interpolation including a first segment for a field strength range in which a high frequency cut is performed on the audio signal, and a second segment in which the high frequency cut is not performed on the audio signal.

The segmented interpolation may include a third segment for a field strength range in which the channel separation of the audio output signal is continuously increased from Mono to full Stereo, in accordance with the field strength.

In another embodiment of the invention the quality indicator is a quality value, AQ, of the first frequency signal determined by applying a synergistic function of a field strength quality value, Q(FS), and a distortion index, $I_D$, of the signal, where the distortion index $I_D$ decreases as distortion D increases, the field strength quality value Q(FS) being determined by:

detecting the field strength of the received, first frequency signal; and
performing a non-linear conversion on the detected field strength to convert it into the field strength quality value Q(FS).

The synergistic function may be a multiplication of the field strength quality value Q(FS) and the distortion index $I_D$ of the signal.

The quality value AQ may determined according to the relationship:

$$AQ = Q(FS) * (k*I_D),$$

where $I_D$ is the distortion index $I_D$ and k is a calibration value previously determined for the radio tuner.

The distortion D may be calculated from:

$$D = b*M + c*N,$$

where M is a value of the multipath, N is a value of the noise, and b and c is a calibration value previously determined for the radio tuner.

According to a second aspect of the invention, there is provided a radio apparatus for in-vehicle use, operable in accordance the method of the present invention.

Reference is now made, by way of example only, to the accompanying drawings, in which:

Fig. 1 shows multipath signal propagation from a transmitter to a radio receiver in a vehicle;
Fig. 2 shows blocks of data in an RDS group in the RDS data link layer;
Fig. 3 shows a radio receiver apparatus operable in accordance with an embodiment of the invention;
Fig. 4 illustrates a "tunnel situation", when a tunnel alternative frequency is available;
Fig. 5 is a measurement graph showing received signal strength (field strength) on the horizontal axis and output signal and noise values on the vertical axis, for a particular type of radio receiver;
Fig. 6 is a segmented interpolation graph reflecting a non-linear relationship between field strength and audio quality of the output audio sound;
Figure 7 illustrates a "tunnel situation", when a tunnel alternative frequency is not available.

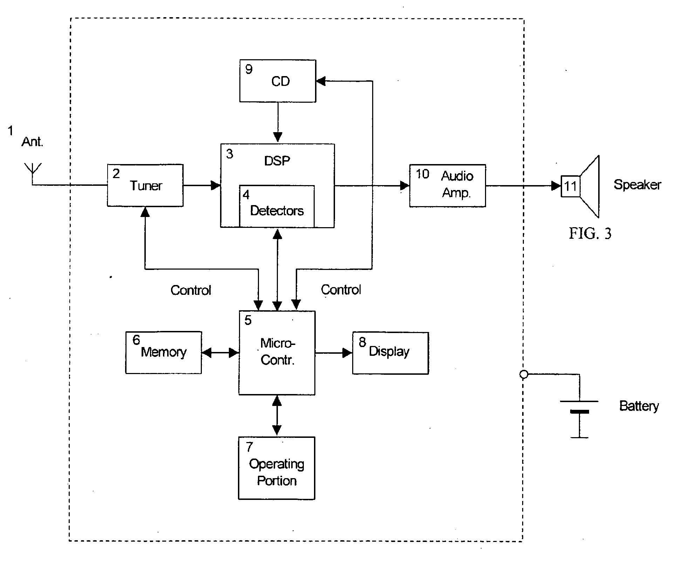

Fig. 3 shows a radio receiver apparatus according to an embodiment of the invention. The apparatus includes an antenna 1, a tuner 2, a digital signal processor (DSP) 3 including detectors 4, a microcontroller (CPU) 5, memory 6, an operating portion 7, a display portion 8, a CD input 9, audio amplifier circuitry 10 and speakers 11. The apparatus also has a connector for connection to the power supply of the vehicle (i.e. to the vehicle battery).

Through the antenna 1 incoming radio waves can be picked up and input into the apparatus. The tuner 2 can be tuned to different frequencies, so that different radio programmes can be received. The DSP 3 performs signal processing in the digital domain on the signal output by the tuner 2. The detectors 4 enable indicators of the received signal quality to be detected. The CPU 5 is in overall control of the apparatus, for example it controls the frequency to which the tuner is tuned. Memory 6 associated with the CPU 5 stores program code for operating the apparatus, and also stores operating information such as alternative frequency information, which may be dynamically updated during use.

The operating portion 7 is provided to enable a user to input operation instructions, such as an instruction as to the radio station to be tuned to or the sound volume to be output. The operating portion could be, for example, a combination of buttons and knobs on the front panel of the apparatus. The display 8 enables information to be displayed to the user, such as whether the input signal is from the radio or a CD, and which radio station is being listened to. The display 8 could be an LCD display. The CD input 9 enables a CD to be input into the apparatus and played. The speakers 11 output the desired audio sound, after processing by the audio amplifier circuitry 10, to the listeners (users).

The detectors 4 include a field strength detector for detecting the signal strength of the received frequency signal. The signal strength is directly related to signal quality because the signal-to-noise ratio mainly depends on it. This detector is calibrated to compensate for tolerances of the analogue components of the receiver hardware.

The detectors 4 also include a multipath detector for detecting the multipath of the signal. This detector evaluates amplitude fluctuations of the received signal. It does not require any alignment.

An Ultra Sonic Noise (USN) detector is also included in the detectors 4. This detector detects the amplitude of the high frequency content of the multiplex (MPX) signal. This is measured in the frequency range of around 80-150kHz. The USN detector gives information on noise due to an adjacent channel.

In use, a user sets the apparatus to a particular radio station using the operating portion 7 and the CPU 5 sets the tuner 2 to a frequency on which that station is broadcast. The quality of the received signal is then monitored by the detectors 4 and the CPU 5. In other words, certain quality indicators of the signal are detected periodically by the detectors 4 and analysed by the CPU 5.

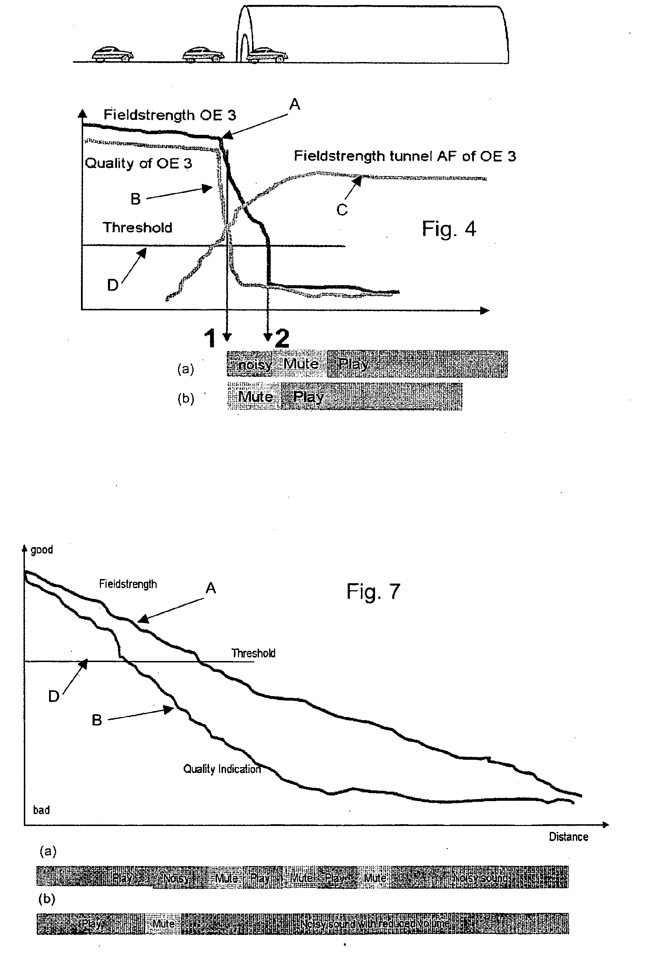

Referring now to Figure 4, a brief explanation will be given of the change in radio reception conditions which can arise upon entry into a tunnel ("tunnel situation").

In Figure 4, curve A (Fieldstrength of OE 3) indicates the detected field strength of a radio signal of a radio station (OE 3) being listened to. As can be seen, field strength falls dramatically upon entry into the tunnel. In the prior art only the field strength is checked. If the field strength value falls to a certain threshold (D) then an alternative frequency (AF) search is executed. As this takes some time a mute occurs, but because the AF search is started at a low field strength (indicated at 2 in the Figure) the sound is noisy before the mute (see (a) in Figure 4). This is relatively unsatisfactory for the listener. In principle the same action is executed by the prior art in tunnel situations as in weak signal areas.

The inventors have had the insight that a more rapid detection of changed reception conditions upon entry into a tunnel, and a more satisfactory response, can be attained by adopting an different procedure.

In this procedure, not field strength is monitored for detecting tunnel entry, but rather a quality value is monitored. An example of the behaviour of such a quality value is indicated by curve B (Quality of OE 3) in Figure 4.

In one embodiment of the present invention the quality value monitored is a field strength quality value Q(FS) related to the actual field strength measured by the field strength detector. It has been known that field strength directly relates to signal quality because of the dependence of the signal-to-noise ratio S/N on it.

One aspect the present inventors have considered, however is that the relationship between the field strength and the audio quality heard by a user is not a linear relationship as has previously been assumed. In other words, depending upon the absolute value of the field strength, the effect of an increase or decrease in the field strength varies.

Using the field strength quality value Q(FS) instead of simply using the field strength FS leads to a much improved correlation between the field strength and the sound quality perceived by a user is realised.

The inventors have further had the insight that this field strength quality value Q(FS) can be exploited to provide a more rapid detection of a tunnel situation and a more satisfactory response upon entry into a tunnel.

The derivation of a field strength quality value Q(FS) as used in this first embodiment of the invention is explained below.

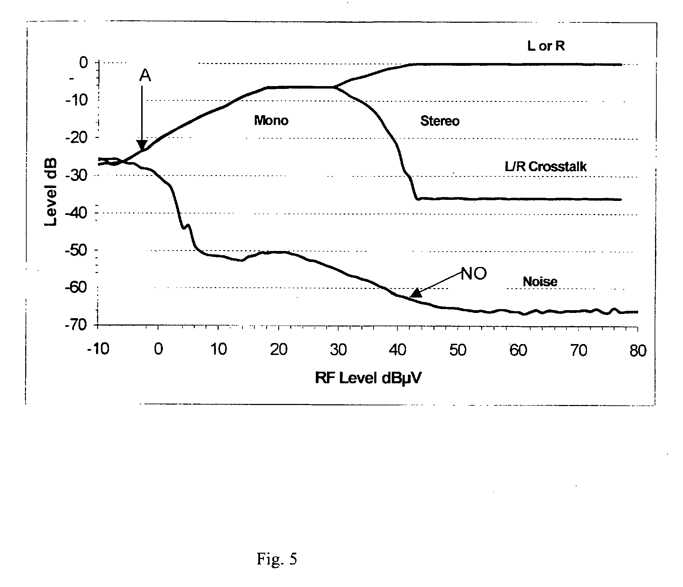

Figure 5 is a graph showing the received signal strength (field strength) on the horizontal axis and the output signal and noise values on the vertical axis, for a particular type of radio receiver.

In Fig. 5, the line A represents the output signal, the lines L and R represent the left and right output signals (channels) when the output signal is output in stereo, and the line NO represents the noise. The output signal is only output in stereo if the signal strength of the received signal is above a minimum level.

It can be seen from Fig. 5 that when the received signal has a very low field strength, for example in the range of about 0-20 dBμV, the signal-to-noise ratio is very poor but nevertheless increases significantly over this range. Hence, in this field strength range, each extra dBμV of signal strength will result in a marked improvement in the S/N ratio.

At about 30 dBμV stereo is opened and the radio apparatus outputs the output signal as left and right stereo signals. In the region from about 20-30 dBμV, the S/N ratio is still much improved for each extra dBμV of the received signal, but the effect is less marked than in the lower field strength region of 0-20 dBμV.

In the region from about 30 to 44 dBμV, during which the audio channel separation is continuously increased from mono to maximum stereo, there is a much less significant improvement in the S/N ratio for each extra dBμV of the received signal.

Further, after about 44 dBμV at which the stereo is maximum open, there is no longer an increase in the S/N ratio for additional increases in the field strength. Hence, simply to use the detected field strength as an indicator of quality results in an inaccurate reflection of the actual audio quality perceived by a listener, and if used in the recognition of tunnel entry leads to unsatisfactory detection of the tunnel situation and an unsatisfactory response thereto, as discussed above. Advantageously, according to the first embodiment of the invention, a field strength quality value Q (FS) is used instead of the field strength FS.

The field strength quality value Q(FS) is determined by taking account of the non-linear relationship between the actual detected field strength and the signal-to-noise ratio of the output audio signal. The correlation between the field strength and the signal-to-noise ratio of the output signal can be realised in various ways.

One way of performing the correlation is to generate a table (for the radio receiver type to be used) in which actual detected field strength values are converted into field strength quality values Q(FS) in accordance with the relationship between each field strength value and the S/N ratio. In other words, by generating a measurement graph such as that shown in Fig. 5, a field strength quality value can be assigned to each field strength in accordance with the signal-to-noise ratio at each field strength. The values can then be written into a look-up table and stored in the memory 6 associated with the CPU 5.

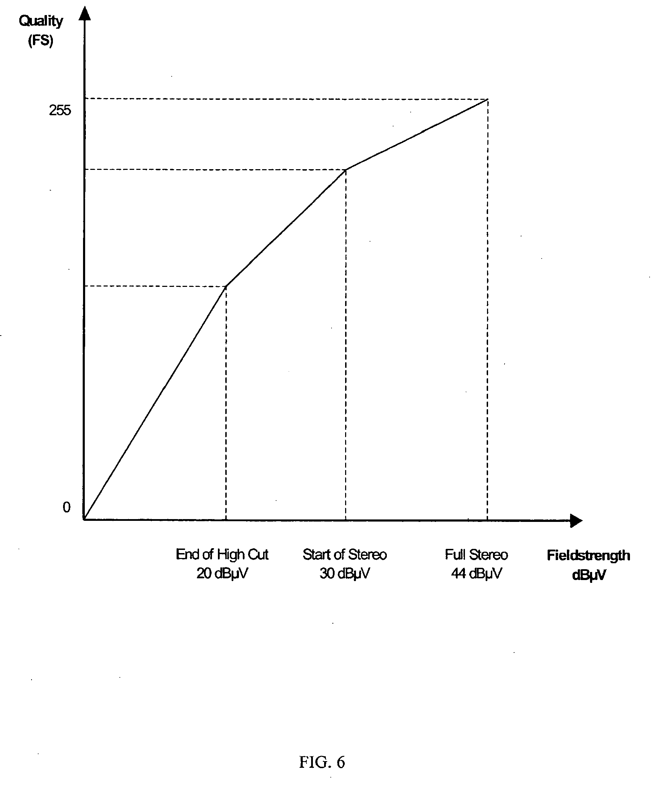

An alternative way of performing the correlation is to use the graph of Fig. 5 to produce a segmented interpolation graph of the type shown in Fig. 6. Here, the horizontal axis shows the field strength in dBμV and the vertical axis shows the field strength quality value Q(FS) (as a number, no unit).

On the graph, a first segment is provided for a field strength in the range of 0 to 20 dBμV, a second segment is provided for a field strength in the range from 20 to 30 dBμV, and a third segment is provided for a field strength from 30 to 44 dBμV. Above 44 dBμV, additional increases in the field strength do not additionally increase the field strength quality value Q(FS).

It can be seen that the gradient of the first segment is steeper than that of the second segment, which is in turn steeper than that of the third segment. In other words, the non-linear relationship between the field strength of the received sound and the S/N ratio of the output sound is reflected by the different segments of the graph. The interpolation data of the graph is stored in the memory 6 associated with the CPU 4, for example as segmented interpolation algorithm (s). It is then used to determine a field strength quality value Q(FS) for a particular field strength by interpolation.

A further way of converting the detected field strength to a field strength quality value Q(FS) would be to formulate a non-linear equation reflecting the varying influence of the field strength on the signal-to-noise ratio (and hence on the overall quality), or to employ a separate linear equation for each field strength range (e.g. to employ different linear equations corresponding to the gradients of the segments shown in the graph of Fig. 6).

With Q(FS) calculated in one of these ways it has been determined that a more rapid detection of tunnel entry can be provided, and a more satisfactory response to the changed reception conditions in the tunnel.

Referring again to Figure 4, it can be seen that curve B, representing a quality parameter - Q(FS) - (Quality of OE 3) falls off more rapidly and strongly in the immediate vicinity of tunnel entry. In the first embodiment of the present invention the quality parameter Q(FS) is monitored. In addition it is monitored how fast and strong the parameter changes. If this happens very fast and strong, and the value of the parameter falls below a threshold set for the purpose (D) a tunnel situation is considered to exists and an AF search starts immediately (see 1 in Figure 4). This requires a mute, but the advantage now is that a tunnel situation is detected earlier, and due to the fact that the quality parameter Q(FS) indicates a tunnel situation earlier (than field strength) no noisy sound is to be heard before the mute: compare (b) and (a) in Figure 4.

For detecting the how fast and strongly the quality parameter changes, a number of different methods may be used. For example, a kind of "double threshold" method can be used in is determined whether the magnitude and the speed of the fall in value of the quality parameter are greater than selected magnitude and speed threshold values, by detecting a fall in the value of the quality parameter from a second quality parameter threshold value, greater than the first quality parameter threshold value (D in Fig. 4) by the selected magnitude threshold value, to the first quality parameter threshold value, and determining the time period over which the fall from second to first quality parameter threshold value occurred.

Alternatively, it can be determined whether the magnitude and the speed of the fall in value of the quality parameter are greater than selected threshold values therefor by detecting rates of change of the value of the quality parameter, and evaluating the rates of change detected during a predetermined period up to the value of the quality parameter falling below the quality parameter threshold value D.

Further, it can be determined whether the magnitude and the speed of the fall in value of the quality parameter are greater than selected threshold values therefore by detecting the values of the quality parameter at predetermined intervals and evaluating those values detected at intervals during a predetermined period up to the value of the quality parameter falling below the quality parameter threshold value D.

Figure 4 illustrates a case in which the radio station being listened to before tunnel entry is transmitted on a different frequency in the tunnel (a tunnel alternative frequency or tunnel AF). The field strength of this tunnel AF is indicated by curve C in Figure 4 (Fieldstrength tunnel AF of OE 3). As shown at (b) in Figure 4, after the AF search carried out during the mute, the tunnel AF is tuned to and played. This happens more rapidly than in the prior art case (as shown at (a)) in which only field strength is monitored, but nonetheless it can be expected that the tunnel AF is of sufficient strength to provide satisfactory reception.

Figure 7 illustrates a case in which no tunnel AF is available.

In such a case the prior art behaves in the same way as in a tunnel with AF, but an alternative frequency (tunnel AF) is not found. Therefore the original frequency is tuned and played again. After some seconds another AF search is started, followed by a switch back to the original frequency. This may be repeated and may continue during the whole drive through the tunnel. After a number of switches, further AF searches may no longer occur, in which case the listener is presented with noisy sound, as illustrated at (a) in Figure 7.

The embodiment of the present invention also behaves the same as in a tunnel situation with AF, but in the embodiment of the invention the tunnel (or tunnel situation) has been recognised and an appropriate adapted procedure can be taken. Thus, if no alternative frequency is found after the first AF search with a mute, the original station is tuned to and played with reduced volume. Although the resulting sound may be noisy (as indicated at (b) in Figure 7) it is of reduced volume and this behaviour is more satisfactory and corresponds more to the expectation of customers for desirable radio behaviour when driving through a tunnel without alternative frequency.

To avoid the radio being locked to a frequency (either the original frequency or, if available, a tunnel AF), scans for other frequencies may be carried out at appropriate intervals (for example several tens of seconds). This will eventually enable tuning to a "tunnel exit" frequency of the radio station listened to, upon emergence from the tunnel (if such a tunnel exit frequency, which may be different from the frequency at the tunnel entrance, is available).

In another embodiment of the present invention, a different quality parameter AQ, also related to field strength but also taking into account distortion, may be used in place of Q(FS) as described above. The same results and advantages can be provided.

Quality indicators include the field strength, multipath and noise detected by the field strength detector, the multipath detector and the noise detector of the radio receiver, respectively. In this other embodiment of the invention quality value AQ is evaluated for the received signal of the current (tuned-to) frequency using these parameters. This quality value AQ is calculated using a synergistic function. According to the present embodiment, the synergistic function is realised by the equation (1):

$$AQ = Q(FS) * (k*I_D) \qquad \qquad \ldots (1)$$

where Q(FS) is the field strength quality value related to the field strength detected by the field strength detector (and employed in the first embodiment of the invention described above), $I_D$ is a distortion index and k is a calibration parameter. The distortion index $I_D$ is an index which increases in value as distortion in the signal decreases in value, and decreases as distortion increases. The distortion D depends on the multipath and noise present and may be calculated by summing these effects using an equation (2):

$$D = b*M + c*N \qquad \qquad \ldots (2)$$

where M is the multipath determined by the multipath detector, N is the noise determined by the Ultra Sonic Noise detector, and b and c are calibration parameters. Thus, the multipath and the noise have a linear influence on the distortion.

Calculation of the quality value AQ from the values detected by the field strength, multipath and noise detectors of the detectors 4 results in a single value (quality value AQ) which, it has been found by the inventors, accurately represents the actual audio quality experienced by a listener, i.e. by the user in the vehicle.

By calculating the quality of the audio signal in this way, the combined synergistic effect of each of the key individual factors affecting the audio quality, namely of the field strength, multipath and noise, is accurately reflected. In particular, for a given field strength, a change in the quality value due to an increase in distortion is accurately reflected, because the change depends on the field strength value and not just on the change in the distortion. Hence, a judgement as to the actual audio quality of the current (tuned-to, presently received) frequency as perceived by a listener can be made.

By evaluating signal quality in this way, a major improvement is made over just considering the field strength, or considering each of the field strength, the multipath and the noise in isolation.

As already mentioned, the values of M and N are values output by the multipath and USN detectors. The distortion D is calculated from these values according to the equation (2), and the obtained value of the distortion D is then transformed to a suitable distortion index $I_D$ for equation (1) as to enable the quality value AQ to be calculated.

As stated above, the parameters k, b and c are calibration parameters. The values of the calibration parameters depend on the antenna system and on the tuner hardware. The values of these parameters are determined in advance for the radio receiver and are then set. In other words, pre-set values of the parameters are loaded into the memory 6 associated with the CPU 5 before sale of the receiver to an end user.

As outlined above, the values of the calibration parameters are determined for a particular radio receiver/ antenna combination and are loaded into the radio receiver before sale to an end user.

One mechanism for determining the values of the calibration parameters is through testing using a sample listener panel. The members of the panel are people who have a very good sense of hearing, for example those with 'perfect pitch'. In the testing, sound (e.g. music) is output through the radio receiver apparatus and is listened to by the members of the panel. Known amounts of distortion, caused by multipath and noise, are then introduced into the signal, and the quality of the output sound is rated by the members of the panel. This can be performed for different field strengths also. By using the known noise, multipath and field strength values, and the perceived quality values given by the panel, the optimum values of the parameters can be determined.

By using the equation (1) in which the audible sound quality AQ depends upon the field strength, multipath and noise according to a relationship determined using the quality perceived by a listener panel, it is ensured that the determined audible sound quality AQ accurately reflects the sound being heard in the vehicle. It also enables a tunnel situation to be recognised and responded to as is the case with the quality parameter Q(FS) of the first embodiment.

In use, the field strength detector, the multipath detector and the noise detector of the detectors 4 periodically monitor the field strength, multipath and noise values of the received signal, i.e. of the frequency signal currently tuned to. The CPU 5 then calculates the value AQ from these detected values. For example, the CPU 5 takes the detected field strength and looks up the corresponding field strength quality value Q(FS) in a look-up table stored in the memory 6. The CPU then retrieves the values of the parameters k, b and c from the memory 6 and calculates the audible sound quality AQ using the values of k, b, c, M, N and Q(FS).

The radio receiver may also use further measures to maintain satisfactory audio quality under various reception conditions. These further measures include mono stereo blend, high cut, soft mute and bandwidth control.

Mono stereo blend makes use of a gliding mono/stereo separation depending on signal level and multipath distortion. The CPU 5 controls mono stereo blend. As can be seen in the graph of Fig. 5, below a field strength of the received signal of about 30 dBμV the CPU 5 controls the output to be mono. Between about 30 and 44 dBμV stereo is opened until it reaches maximum stereo. In this way, distortions at low field strength are made less noticeable by outputting the audio in mono.

High cut is the reduction of higher audio frequencies in case of increasing noise and audio distortion, because the most annoying audio distortions for a listener are those in the high frequency band. To perform high cut, the CPU 5 causes the received signal to be passed through an adaptive low pass filter to reduce this part of the audio frequency spectrum. The cut off frequency and the suppression rate can be set by parameters which are evaluated during test drives.

Soft mute is an adaptive reduction of the audio volume at low field strength values where the signal-to-noise ratio is bad. Control of soft mute is performed by the CPU. The reduction of the audio level makes distortion and noise less annoying due to the properties of the human ear. Start and slope of soft mute is set by parameters and can be evaluated during test drives.

Bandwidth control becomes active if the IF filter is not able to suppress adjacent channel interference. In this case, spectrum overlapping occurs between the tuned-to channel and the adjacent channels. This happens mainly in regions with a channel grid of 100 kHz. The selectivity of the IF filter needs to be adaptive, so that the bandwidth of the channel filter can be reduced under the control of the CPU 5 if necessary. This bandwidth reduction results in a suppression of the adjacent channel signals, while keeping the distortion of the desired signal low.

If the CPU 5 causes the tuner 2 to switch from a presently-received frequency which has a weak signal to a new frequency, at the time of switching it will cause high cut and mono stereo blend to be applied so as to make the change smooth. In other words, the CPU 5 will use these measures to ensure that an abrupt change is not heard by a listener. The CPU 5 may also cause bandwidth control to be applied when performing such a switch.

In addition, in weak signal areas in which no alternative frequency is available having a satisfactory AQ value, the CPU 5 will optimise the sound output by using high cut, stereo blend and bandwidth control.

**Claims**

1.  A method of operating a radio tuner (2), comprising:

    monitoring a quality indicator (B) of a first frequency signal (OE3), to which the radio tuner (2) is tuned; **characterised by** further comprising
    when the value of the quality indicator (B) falls below a predetermined first quality indicator threshold value (D), and the magnitude and the speed of the fall are equal to or greater than predetermined magnitude and speed threshold values,
    searching for an alternative frequency signal (AF OE3) carrying the same radio programme as the first frequency signal (OE3).

2.  A method as claimed in claim 1, wherein it is determined whether the magnitude and the speed of the fall in value of the quality indicator (B) are greater than the predetermined magnitude and speed threshold values, by detecting a fall in the value of the quality parameter from a second predetermined quality indicator threshold value, greater than the first quality indicator threshold value by said predetermined magnitude threshold value, to the first quality indicator threshold value, and determining the time period over which the fall from second to first quality indicator threshold value occurred.

3.  A method as claimed in claim 1, wherein it is determined whether the magnitude and the speed of the fall in value of the quality indicator (B) are greater than the predetermined magnitude and speed threshold values by detecting rates of change of the value of the quality indicator, and evaluating the rates of change detected during a predetermined period up to the value of the quality indicator falling below the first quality indicator threshold value.

4.  A method as claimed in claim 1, wherein it is determined whether the magnitude and the speed of the fall in value of the quality indicator (B) are greater than the predetermined magnitude and speed threshold values by detecting the values of the quality indicator at predetermined intervals and evaluating those values detected at intervals during a predetermined period up to the value of the quality indicator falling below the first quality indicator threshold value.

5.  A method as claimed in claim 1, 2, 3 or 4, wherein upon the searching for an alternative frequency signal (AF OE3) carrying the same radio programme as the first frequency signal (OE3), if no such alternative frequency signal is found, the radio remains tuned to the first, frequency signal and the radio programme is played at reduced volume.

6.  A method according to any of claims 1 to 5, wherein the quality indicator (B) is a field strength quality value Q(FS) determined by:

    detecting the field strength of the received, first frequency signal (OE3); and
    performing a non-linear conversion on the detected field strength to convert it into the field strength quality value Q(FS).

7.  A method according to claim 6, wherein the non-linear conversion is performed based on a non-linear relationship between the field strength of the received signal and the signal-to-noise ratio of the audio output signal resulting from the received signal.

8.  A method according to claim 7, wherein the non-linear conversion is performed using a segmented interpolation, said segmented interpolation including a first segment for a field strength range in which a high frequency cut is performed on the audio signal, and a second segment in which the high frequency cut is not performed on the audio signal.

9.  A method according to claim 8, wherein the segmented interpolation includes a third segment for a field strength range in which the channel separation of the audio output signal is continuously increased from Mono to full Stereo, in accordance with the field strength.

10. A method according to any of claims 1 to 5, wherein the quality indicator (B) is a quality value, AQ, of the first frequency signal determined by applying a synergistic function of a field strength quality value, Q(FS), and a distortion index, $I_D$, of the signal, where the distortion index $I_D$ decreases as distortion D increases, the field strength quality value Q(FS) being determined by:

> detecting the field strength of the received, first frequency signal (OE3); and
> performing a non-linear conversion on the detected field strength to convert it into the field strength quality value Q(FS).

11. A method according to claim 10, wherein the synergistic function is a multiplication of the field strength quality value Q(FS) and the distortion index $I_D$ of the signal.

12. A method according to claim 10, wherein the quality value AQ is determined according to the relationship:

$$AQ = Q(FS) * (k*I_D),$$

where $I_D$ is the distortion index $I_D$ and k is a calibration value previously determined for the radio tuner.

13. A method according to any of claims 10 to 12, wherein the distortion D is calculated from:

$$D = b*M + c*N,$$

where M is a value of the multipath, N is a value of the noise, and b and c is a calibration value previously determined for the radio tuner.

14. A radio apparatus for in-vehicle use, operable in accordance with a method as claimed in any preceding claim.

**Patentansprüche**

1. Betriebsverfahren für einen Funkabstimmer (2), umfassend
Überwachen eines Qualitätsindikators (B) eines ersten Frequenzsignals (OE3), auf welches der Funkabstimmer (2) eingestellt ist; **dadurch gekennzeichnet, dass** es zudem umfasst
fällt der Wert des Qualitätsindikators (B) unter einen vorbestimmten ersten Grenzwert (D) für den Qualitätsindikator, und sind Größe und Geschwindigkeit des Abfallens gleich oder größer als vorbestimmte Grenzwerte für Größe und Geschwindigkeit,
Suchen nach einem alternativen Frequenzsignal (AF OE3), welches das gleiche Radioprogramm als das erste Frequenzsignal (OE3) überträgt.

2. Betriebsverfahren gemäß Anspruch 1, wobei festgestellt wird, ob die Größe und Geschwindigkeit des Abfallens des Werts des Qualitätsindikators (B) größer als die vorbestimmten Grenzwerte für Größe und Geschwindigkeit sind, durch Erfassen eines Abfallens des Werts des Qualitätsparameters aus einem zweiten vorbestimmten Grenzwert für den Qualitätsindikator, der um den vorbestimmten Grenzwert für Größe größer ist als der erste vorbestimmten Grenzwert für den Qualitätsindikator, zum ersten vorbestimmten Grenzwert für den Qualitätsindikator, und Feststellen der Dauer über welche das Abfallen vom zweiten zum ersten Grenzwert für den Qualitätsindikator erfolgt ist.

3. Betriebsverfahren gemäß Anspruch 1, wobei festgestellt wird, ob die Größe und Geschwindigkeit des Abfallens des Werts des Qualitätsindikators (B) größer als vorbestimmte Grenzwerte für Größe und Geschwindigkeit sind, durch Erfassen einer Änderungsrate des Werts des Qualitätsindikators, und Abschätzen der während einer vorbestimmten Dauer erfassten Änderungsraten bis zum Wert, bei dem der Qualitätsindikator unter den ersten Grenzwert für den Qualitätsindikator fällt.

**4.** Betriebsverfahren gemäß Anspruch 1, wobei festgestellt wird, ob die Größe und Geschwindigkeit des Abfallens des Werts des Qualitätsindikators (B) größer als die vorbestimmten Grenzwerte für Größe und Geschwindigkeit sind, durch Erfassen der Werte des Qualitätsindikators zu vorbestimmten Abständen und Abschätzen dieser erfassten Werte an Abständen während einer vorbestimmten Dauer bis zum Wert, bei dem der Qualitätsindikator unter den ersten Grenzwert für den Qualitätsindikator fällt.

**5.** Betriebsverfahren gemäß Anspruch 1, 2, 3 oder 4, wobei beim Suchen nach einem alternativen Frequenzsignal (AF OE3), welches das gleiche Radioprogramm als das erste Frequenzsignal (OE3) überträgt, wird kein solches alternatives Frequenzsignal gefunden, das Radio auf das erste Frequenzsignal eingestellt bleibt und das Radioprogramm mit verringerter Lautstärke gespielt wird.

**6.** Betriebsverfahren gemäß irgendeinem der Ansprüche 1 bis 5, wobei der Qualitätsindikator (B) ein Feldstärkenqualitätswert Q(FS) ist, festgestellt durch
Erfassen der Feldstärke des erfassten ersten Frequenzsignals (OE3); und
Durchführen einer nichtlinearen Konvertierung der erfassten Feldstärke, um sie in den nichtlinearen Feldstärkenqualitätswert Q(FS) umzuwandeln.

**7.** Betriebsverfahren gemäß Anspruch 6, wobei die nichtlineare Konvertierung ausgeführt wird auf der Basis einer nichtlinearen Beziehung zwischen der Feldstärke des empfangenen Signals und dem Signal-zu-Rausch-Verhältnis des vom empfangenen Signal stammenden Audioausgangssignals.

**8.** Betriebsverfahren gemäß Anspruch 7, wobei die nichtlineare Konvertierung ausgeführt wird mit einer segmentierten Interpolation, wobei die segmentierte Interpolation ein erstes Segment enthält für einen Feldstärkenbereich, in dem eine Hochfrequenzschnitt am Audiosignal ausgeführt wird, und ein zweites Segment, in dem der Hochfrequenzschnitt nicht am Audiosignal ausgeführt wird.

**9.** Betriebsverfahren gemäß Anspruch 8, wobei die segmentierte Interpolation ein drittes Segment enthält für einen Feldstärkenbereich, in welchem die Kanaltrennung des Audioausgangssignal stufenlos erhöht wird von Mono zu voll-Stereo, gemäß der Feldstärke.

**10.** Betriebsverfahren gemäß irgendeinem der Ansprüche 1 bis 5, wobei der Qualitätsindikator (B) ein Qualitätswert, AQ, des ersten Frequenzsignals ist, festgestellt durch Anwendung einer synergistischen Funktion eines Feldstärkenqualitätswerts, Q(FS), und eines Zerrindex, $I_D$, des Signals, wobei der Zerrindex $I_D$ abnimmt, wenn die Verzerrung sich erhöht, wobei der Feldstärkenqualitätswert, Q(FS), bestimmt wird durch
Erfassen der Feldstärke des erfassten ersten Frequenzsignals (OE3); und
Durchführen einer nichtlinearen Konvertierung der erfassten Feldstärke, um sie in einen nichtlinearen Feldstärkenqualitätswert Q(FS) umzuwandeln.

**11.** Betriebsverfahren gemäß Anspruch 10, wobei die synergistische Funktion eine Multiplikation des Feldstärkenqualitätswerts Q(FS) und des Zerrindex $I_D$ des Signals ist.

**12.** Betriebsverfahren gemäß Anspruch 10, wobei der Qualitätswert AQ festgestellt wird gemäß der Beziehung:

$$AQ = Q(FS) * (k*I_D),$$

worin $I_D$ der Zerrindex $I_D$ ist und k ein für den Funkabstimmer vorbestimmter Kalibrierungswert.

**13.** Betriebsverfahren gemäß irgendeinem der Ansprüche 10 bis 12, wobei die Verzerrung D ausgerechnet wird aus:

$$D = b*M + c*N;$$

wobei M ein Mehrwegwert ist, N ein Wert des Rauschens, und b und c für den Funkabstimmer vorbestimmte Kalibrierungswerte sind.

**14.** Funkvorrichtung für den Betrieb in einem Fahrzeug, nutzbar mit einem Verfahren aus irgendeinem vorherigen Anspruch.

**Revendications**

**1.** Procédé d'exploitation d'un tuner radio (2), comprenant :

la surveillance d'un indicateur de qualité (B) d'un premier signal de fréquence (OE3) sur lequel le tuner radio (2) est accordé, **caractérisé par** le fait de comprendre en outre
lorsque la valeur de l'indicateur de qualité (B) tombe en dessous d'une première valeur seuil d'indicateur de qualité prédéterminée (D),
et l'ampleur et la vitesse de la chute sont supérieures ou égales à des valeurs seuils d'ampleur et de vitesse prédéterminées,
la recherche d'un signal de fréquence alternatif (AF OE3) portant le même programme radio que le premier signal de fréquence (OE3).

**2.** Procédé selon la revendication 1, dans lequel il est déterminé si l'ampleur et la vitesse de la chute de valeur de l'indicateur de qualité (B) sont supérieures aux valeurs seuils d'ampleur et de vitesse prédéterminées en détectant une chute de la valeur du paramètre de qualité à partir d'une seconde valeur seuil d'indicateur de qualité prédéterminée, supérieure à la première valeur seuil d'indicateur de qualité par ladite valeur seuil d'ampleur prédéterminée, à la première valeur seuil d'indicateur de qualité, et en déterminant la période de temps au cours de laquelle la chute de la seconde à la première valeur seuil d'indicateur de qualité s'est produite.

**3.** Procédé selon la revendication 1, dans lequel il est déterminé si l'ampleur et la vitesse de la chute de valeur de l'indicateur de qualité (B) sont supérieures aux valeurs seuils d'ampleur et de vitesse prédéterminées en détectant des taux de changement de la valeur de l'indicateur de qualité, et en évaluant les taux de changement détectés au cours d'une période prédéterminée jusqu'à la chute de la valeur de l'indicateur de qualité en dessous de la première valeur seuil d'indicateur de qualité.

**4.** Procédé selon la revendication 1, dans lequel il est déterminé si l'ampleur et la vitesse de la chute de valeur de l'indicateur de qualité (B) sont supérieures aux valeurs seuils d'ampleur et de vitesse prédéterminées en détectant les valeurs de l'indicateur de qualité à des intervalles prédéterminés et en évaluant ces valeurs détectées à des intervalles au cours d'une période prédéterminée jusqu'à la chute de la valeur de l'indicateur de qualité en dessous de la première valeur seuil d'indicateur de qualité.

**5.** Procédé selon la revendication 1, 2, 3 ou 4, dans lequel, suite à la recherche d'un signal de fréquence alternatif (AF OE3) portant le même programme radio que le premier signal de fréquence (OE3), si aucun signal de fréquence alternatif de ce type n'est trouvé, la radio reste accordée sur le premier signal de fréquence et le programme radio est joué à volume réduit.

**6.** Procédé selon l'une quelconque des revendications 1 à 5, dans lequel l'indicateur de qualité (B) est une valeur de qualité d'intensité de champ Q(FS) déterminée par :

la détection de l'intensité de champ du premier signal de fréquence reçu (OE3) ; et
la réalisation d'une conversion non linéaire sur l'intensité de champ détectée pour la convertir en la valeur de qualité d'intensité de champ Q(FS).

**7.** Procédé selon la revendication 6, dans lequel la conversion non linéaire est réalisée en fonction d'un rapport non linéaire entre l'intensité de champ du signal reçu et le rapport signal/bruit du signal de sortie audio résultant du signal reçu.

**8.** Procédé selon la revendication 7, dans lequel la conversion non linéaire est réalisée en utilisant une interpolation segmentée, ladite interpolation segmentée incluant un premier segment pour une plage d'intensité de champ dans laquelle une coupure de fréquence élevée est réalisée sur le signal audio, et un deuxième segment dans lequel la coupure de fréquence élevée n'est pas réalisée sur le signal audio.

**9.** Procédé selon la revendication 8, dans lequel l'interpolation segmentée inclut un troisième segment pour une plage d'intensité de champ dans laquelle la séparation de canaux du signal de sortie audio est augmentée de manière continue de mono à full stéréo en fonction de l'intensité de champ.

10. Procédé selon l'une quelconque des revendications 1 à 5, dans lequel l'indicateur de qualité (B) est une valeur de qualité, AQ, du premier signal de fréquence déterminée en appliquant une fonction synergique d'une valeur de qualité d'intensité de champ Q(FS) et un indice de distorsion, $I_D$, du signal, où l'indice de distorsion $I_D$ diminue à mesure que la distorsion D augmente, la valeur de qualité d'intensité de champ Q(FS) étant déterminée par :

la détection de l'intensité de champ du premier signal de fréquence reçu (OE3) ; et
la réalisation d'une conversion non linéaire sur l'intensité de champ détectée pour la convertir en la valeur de qualité d'intensité de champ Q(FS).

11. Procédé selon la revendication 10, dans lequel la fonction synergique est une multiplication de la valeur de qualité d'intensité de champ Q(FS) et de l'indice de distorsion $I_D$ du signal.

12. Procédé selon la revendication 10, dans lequel la valeur de qualité AQ est déterminée en fonction du rapport :

$$AQ = Q(FS) * (k*I_D),$$

où $I_D$ est l'indice de distorsion $I_D$ et k est une valeur d'étalonnage précédemment déterminée pour le tuner radio.

13. Procédé selon l'une quelconque des revendications 10 à 12, dans lequel la distorsion D est calculée à partir de :

$$D = b*M + c*N,$$

où M est une valeur de la propagation par trajets multiples, N est une valeur du bruit, et b et c sont une valeur d'étalonnage précédemment déterminée pour le tuner radio.

14. Appareil de radio pour une utilisation dans un véhicule, pouvant être exploité conformément à un procédé selon l'une quelconque des revendications précédentes.

local dispersion

FIG. 1

| Block A | CRC | Block B | CRC | Block C | CRC | Block D | CRC |
|---------|-----|---------|-----|---------|-----|---------|-----|
| 16 | 10 | | | | | | |

FIG. 2

FIG. 3

Fig. 5

FIG. 6

Fieldstrength OE 3

A

Fieldstrength tunnel AF of OE 3

Quality of OE 3

B

C

Threshold

Fig. 4

D

1   2

(a)   noisy  Mute   Play

(b)   Mute   Play

good

Fieldstrength   A

Fig. 7

Threshold

D

B

Quality Indication

bad

Distance

(a)

Play   Noisy   Mute   Play   Mute   Play   Mute   Noisy sound

(b)

Play   Mute   Noisy sound with reduced volume

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 1195897 A
- DE 43188667
- EP 0503202 A